# EUROPEAN PATENT SPECIFICATION

(11) **EP 3 541 160 B1**
(45) Date of publication and mention of the grant of the patent: **19.03.2025**
(21) Application number: 17869330.5
(22) Date of filing: 09.11.2017
(51) Int. Cl.: H05K 9/00, B32B 7/02, C08L 27/16, C08L 65/00, C08L 67/00

(54) **ELECTROMAGNETIC WAVE ABSORBING SHEET**
FOLIE ZUM ABSORBIEREN ELEKTROMAGNETISCHER WELLEN
FEUILLE ABSORBANT LES ONDES ÉLECTROMAGNÉTIQUES

(30) Priority: 10.11.2016 JP 2016219994
(43) Date of publication of application: 18.09.2019
(73) Proprietor: Maxell, Ltd., Kyoto 618-8525 (JP)
(72) Inventor: TOYODA, Masayuki, Kyoto 618-8525 (JP)
(74) Representative: Diehl & Partner
(86) International application number: PCT/JP2017/040470
(87) International publication number: WO 2018/088492

(56) References cited:
- JP-A- 2006 120 836
- JP-A- 2006 120 836
- JP-A- 2013 201 359
- JP-A- 2013 201 359
- JP-A- 2015 173 010
- JP-A- 2015 173 010
- JP-A- 2016 003 312
- JP-A- 2016 003 312
- JP-A- H09 232 787
- JP-A- H09 232 787

## Description

### Technical Field

The present disclosure relates to an electromagnetic-wave absorbing sheet having flexibility. The electromagnetic-wave absorbing sheet of the present disclosure is an electric-wave interference type electromagnetic-wave absorbing sheet that can be designed to absorb electromagnetic waves in a millimeter-wave band from several tens of gigahertz (GHz) to several hundreds gigahertz (GHz) or electromagnetic waves in a still higher frequency band.

### Background Art

Electromagnetic-wave absorbing sheets for absorbing electromagnetic waves have been used to avoid influences of leaked electromagnetic waves to be emitted to the outside from electric circuits and influences of undesirably reflected electromagnetic waves.

Recently, researches on technologies of utilizing high frequency electromagnetic waves, including centimeter waves having a frequency of several gigahertz (GHz), millimeter waves having a frequency of 30 GHz to 300 GHz, and electromagnetic waves having a still higher frequency of one terahertz (THz) as electromagnetic waves in a high frequency band above the millimeter-wave band, have proceeded for mobile communications such as mobile phones, wireless LAN and electric toll collection system (ETC).

There will be a growing demand, in response to such a technical trend of utilizing electromagnetic waves of high frequencies, that electromagnetic-wave absorbers for absorbing unnecessary electromagnetic waves and electromagnetic-wave absorbing sheets, which are sheet-shaped electromagnetic-wave absorbers that provides higher user convenience, can absorb electromagnetic waves in a frequency band equal to or higher than the millimeter-wave band.

As such electromagnetic-wave absorbing sheets, electric-wave interference type (λ/4 type) electromagnetic-wave absorbing sheets are known. In the electric-wave interference type electromagnetic-wave absorbing sheets, an electric resistance film is formed on one surface of a dielectric layer and an electromagnetic-wave shielding layer that reflects electromagnetic waves is formed on the other surface of the dielectric layer. Electromagnetic waves are absorbed by shifting the phase of reflected waves with respect to the phase of incident waves by 1/2 wavelength to make the incident waves and the reflected waves cancel each other out. The electric-wave interference type electromagnetic-wave absorbing sheets can be produced easily and are lightweight as compared with electromagnetic-wave absorbing sheets that magnetically absorb electromagnetic waves by magnetic particles having a large specific gravity, and thus are advantageous in cost reduction.

Conventionally, in the electric-wave interference type electromagnetic-wave absorbing sheets (electromagnetic-wave absorbers), the electric resistance film formed on one surface of the dielectric layer is formed by ion plating, vacuum evaporation, sputtering or the like, using metal oxide such as indium tin oxide (ITO), indium oxide, stannic oxide or zinc oxide, metal nitride, or a mixture of these (see Patent Document 1, Patent Document 2).

Patent Document 3 discloses a transparent conductive sheet including a transparent substrate and a transparent conductive pattern formed on one of the principal surfaces of the transparent substrate.

### Prior Art Documents

### Patent Documents

Patent Document 1: JP H06-120689 A
Patent Document 2: JP H09-232787 A
Patent Document 3: JP 2015-173010 A

### Disclosure of Invention

### Problem to be solved by the Invention

In the conventional electromagnetic-wave absorbing sheets, the electric resistance film formed on the surface of the dielectric layer has a function of matching the surface impedance of the electromagnetic-wave absorbing sheet to the impedance in the air to enable electromagnetic waves to easily enter the electromagnetic-wave absorbing sheet. Therefore, it is necessary to keep the surface electric resistance of the electric resistance film close to a vacuum impedance of 377 Ω/sq (sheet resistance).

Meanwhile, in the electric-wave interference type electromagnetic-wave absorbing sheets, the dielectric layer becomes thinner as the frequency of electromagnetic waves to be absorbed increases, and thus the sheets can have high flexibility. Such thin and bendable electromagnetic-wave absorbing sheets can be attached to various places and improve user convenience; however, an opportunity for the sheets to be bent strongly by users increases. In the electromagnetic-wave absorbing sheets, the electric resistance film formed by sputtering or the like using metal oxide will crack easily by being bent strongly, and the surface electric resistance increases. This collapses impedance matching and deteriorates the electromagnetic-wave absorbing properties.

It is an object of the present disclosure to provide an electromagnetic-wave absorbing sheet that can solve the above conventional problem, specifically, an electric-wave interference type electromagnetic-wave absorbing sheet that can favorably absorb electromagnetic waves in a desired frequency band while having flexibility and being handled easily.

### Means for Solving Problem

In order to solve the above problem, an electromagnetic-wave absorbing sheet disclosed in the present application is an electromagnetic-wave absorbing sheet according to claim 1 having flexibility, including an electric resistance film and a dielectric layer and an electromagnetic-wave shielding layer that are stacked sequentially. The electric resistance film is formed of a conductive organic polymer.

### Effects of the Invention

Since the electric resistance film of the electromagnetic-wave absorbing sheet disclosed in the present application is formed of a conductive organic polymer, the electric resistance film does not crack even when the sheet is being bent strongly, and thus the electromagnetic-wave absorbing sheet can maintain impedance matching and keep high electromagnetic-wave absorbing properties. Therefore, it is possible to constitute an electromagnetic-wave absorbing sheet having high flexibility and favorable electromagnetic-wave absorbing properties at low cost.

### Brief Description of Drawings

[FIG. 1] FIG. 1 is a cross-sectional view illustrating the configuration of an electromagnetic-wave absorbing sheet of this embodiment.
[FIG. 2] FIG. 2 is a graph indicating electromagnetic-wave absorbing properties of electromagnetic-wave absorbing sheets including electric resistance films having different surface electric resistances.

### Description of the Invention

An electromagnetic-wave absorbing sheet disclosed in the present application is an electromagnetic-wave absorbing sheet having flexibility, including an electric resistance film and a dielectric layer and an electromagnetic-wave shielding layer that are stacked sequentially. The electric resistance film is formed of a conductive organic polymer.

With this configuration, the electromagnetic-wave absorbing sheet disclosed in the present application, which is an electric-wave interference type electromagnetic-wave absorbing sheet including an electric resistance film and a dielectric layer and an electromagnetic-wave shielding layer that are stacked sequentially, is less likely to have a problem of cracks on the electric resistance film or the like even when the sheet is bent strongly, thereby maintaining impedance matching and exhibiting high electromagnetic-wave absorbing properties.

In the electromagnetic-wave absorbing sheet disclosed in the present application, it is preferred that the electric resistance film contains poly(3,4-ethylenedioxythiophene) (PEDOT). By doing so, it is possible to easily obtain a surface film having a desired surface electric resistance.

Further, it is preferred that the electric resistance film further contains polystyrene sulfonic acid (PSS) and polyvinylidene fluoride (PVDF). Particularly, the polystyrene sulfonic acid functions as a counter anion of poly(3,4-ethylenedioxythiophene) (PEDOT). Thus, it is possible to constitute an electric resistance film with highly stable electric resistance.

In these cases, it is preferred that the electric resistance film further contains water-soluble polyester. By doing so, the electric resistance film itself can have high weather resistance. Thus, it is possible to constitute a highly reliable electromagnetic-wave absorbing sheet with stable surface electric resistance.

Further, it is preferred that a surface electric resistance of the electric resistance film is in a range from -15% to +20% with respect to a vacuum impedance. By doing so, it is possible to obtain an electromagnetic-wave absorbing sheet achieving proper impedance matching, which is capable of exhibiting sufficient electromagnetic-wave absorbing properties in practical use.

Further, it is preferred that a surface electric resistance of the electromagnetic-wave shielding layer is 1 x 10⁻¹ Ω/sq or less. By doing so, it is possible to obtain an electromagnetic-wave shielding layer that favorably reflects electromagnetic waves incident upon the electromagnetic-wave absorbing sheet.

Further, in the electromagnetic-wave absorbing sheet disclosed in the present application, it is preferred that a thickness of the dielectric layer is set so that the dielectric layer can absorb electromagnetic waves in a high frequency band equal to or higher than a millimeter-wave band. By doing so, it is possible to constitute an electromagnetic-wave absorbing sheet having high flexibility that can absorb electromagnetic waves in a frequency band equal to or higher than the millimeter-wave band.

Moreover, it is preferred that the electromagnetic-wave absorbing sheet further includes an adhesive layer on a back surface of the electromagnetic-wave shielding layer. By doing so, the electromagnetic-wave absorbing sheet can be easily attached to a desired place and handled easily.

Further, it is preferred that the electromagnetic-wave absorbing sheet further includes a protective layer that covers the electric resistance film. By doing so, it is possible to increase the weather resistance of the electric resistance film while effectively preventing the conductive organic polymer of the electric resistance film from being damaged in the handling of the electromagnetic-wave absorbing sheet.

Hereinafter, the electromagnetic-wave absorbing sheet disclosed in the present application will be described with reference to the drawings.

The term "electric waves" can be understood as a type of electromagnetic waves in a broader sense, and therefore the present specification uses the term "electromagnetic waves". For example, electric-wave absorbers are referred to as electromagnetic-wave absorbers in the present specification.

### (Embodiment)

First, the overall configuration of an electromagnetic-wave absorbing sheet of this embodiment will be described.

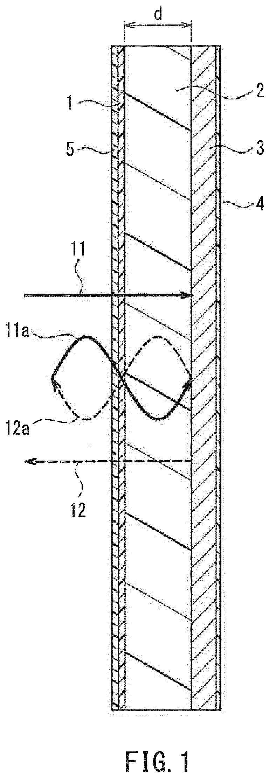

FIG. 1 is a cross-sectional view illustrating the configuration of the electromagnetic-wave absorbing sheet of this embodiment.

FIG. 1 is illustrated for the sake of easy understanding of the configuration of the electromagnetic-wave absorbing sheet of this embodiment, and does not faithfully reflect the actual sizes or thicknesses of members illustrated therein.

The electromagnetic-wave absorbing sheet exemplified in this embodiment is formed by stacking an electric resistance film 1, a dielectric layer 2, and an electromagnetic-wave shielding layer 3. In the electromagnetic-wave absorbing sheet illustrated in FIG. 1, an adhesive layer 4 is stacked on a surface of the electromagnetic-wave shielding layer 3 on a back side, i.e., a side in the electromagnetic-wave shielding layer 3 opposite to a side where the dielectric layer 2 is disposed. A protective layer 5 is stacked on a surface of the electric resistance film 1 on a front side, i.e., a side in the electric resistance film 1 opposite to a side where the dielectric layer 2 is disposed.

In the electromagnetic-wave absorbing sheet of this embodiment, electromagnetic waves 11 incident upon the dielectric layer 2 are reflected at an interface between the dielectric layer 2 and the electromagnetic-wave shielding layer 3 that is disposed on the back side of the dielectric layer 2, and emitted to the outside as reflected waves 12. By adjusting a thickness d of the dielectric layer 2 to 1/4 the wavelength of incident electromagnetic waves (d = λ/4), a phase 11a of the incident waves 11 and a phase 12a of the reflected waves 12 are canceled each other out, whereby electromagnetic waves incident upon the electromagnetic-wave absorbing sheet are absorbed.

Incidentally, d = λ/4 is established when the dielectric layer 2 is air (permittivity ε = 1). When the dielectric layer 2 is a dielectric having permittivity of εᵣ, d = λ/(4(εᵣ)^{1/2}) is established, and the thickness d of the dielectric layer 2 can be reduced by (εᵣ)^{-1/2}. Such a reduction in thickness of the dielectric layer 2 can reduce the thickness of the electromagnetic-wave absorbing sheet as a whole, whereby it is possible to constitute an electromagnetic-wave absorbing sheet having still higher flexibility.

The electromagnetic-wave shielding layer 3 that is stacked on the back side of the dielectric layer 2 reflects incident electromagnetic waves by the surface on the dielectric layer 2 side, i.e., the boundary surface with the dielectric layer 2.

According to the principle of electromagnetic-wave absorption in the electric-wave interference type electromagnetic-wave absorbing sheet of this embodiment, any layer that functions as a reflective layer for reflecting electromagnetic waves can be used as the electromagnetic-wave shielding layer 3, and a metal layer can easily constitute the electromagnetic-wave shielding layer 3. However, since the electromagnetic-wave absorbing sheet of this embodiment as a whole has flexibility, it is not preferable to use a metal plate having a thickness not exhibiting flexibility (e.g., several mm or more) as the electromagnetic-wave shielding layer 3, and it is preferable to constitute the electromagnetic-wave shielding layer 3 using a metal foil, or a metal thin film that is formed by evaporating and depositing a metal material on a thin film made of a nonmetal material such as resin.

The electric resistance film 1 is formed on a front side of the dielectric layer 2, i.e., a side of the dielectric layer 2 from which electromagnetic waves to be absorbed enter, which is opposite to the side where the electromagnetic-wave shielding layer 3 is stacked. The electric resistance film 1 matches impedances between the electromagnetic-wave absorbing sheet and air.

It is important to set the input impedance of the electromagnetic-wave absorbing sheet not to largely differ from the impedance in the air (a vacuum impedance in practice) of 377 Ω when electromagnetic waves propagating through the air enter the electromagnetic-wave absorbing sheet, in order to prevent deterioration of electromagnetic-wave absorbing properties due to reflection or scattering of electromagnetic waves in the entrance into the sheet. In the electromagnetic-wave absorbing sheet of this embodiment, the electric resistance film 1 formed as a conductive organic polymer film imparts flexibility to the electromagnetic-wave absorbing sheet while the electric resistance film 1 does not crack even when the electromagnetic-wave absorbing sheet is strongly bent. Thus, the surface electric resistance does not change, and favorable impedance matching can be maintained.

The adhesive layer 4 is formed on the back side of the electromagnetic-wave shielding layer 3 to make the electromagnetic-wave absorbing sheet easily attachable to a predetermined position. The adhesive layer 4 can be easily formed by application of an adhesive resin paste.

The adhesive layer 4 is not an essential member in the electromagnetic-wave absorbing sheet of this embodiment. In an arrangement of the electromagnetic-wave absorbing sheet to a predetermined position, a member for adhesion may be arranged on a member on which the electromagnetic-wave absorbing sheet is to be attached, or an adhesive may be supplied between the electromagnetic-wave absorbing sheet and an arrangement position, or a double-sided tape may be used.

The protective layer 5 is formed on a front surface of the electric resistance film 1, i.e., an uppermost surface in the electromagnetic-wave absorbing sheet on the electromagnetic-wave incident side, and protects the electric resistance film 1.

The surface electric resistance of the conductive organic polymer constituting the electric resistance film 1 of the electromagnetic-wave absorbing sheet of this embodiment may change when moisture is attached to the surface. Further, since the electric resistance film 1 is made of resin, it may be damaged when a sharp member contacts the surface, or a hard material rubs against the surface. To avoid such a situation, it is preferable to protect the electric resistance film 1 by covering the surface of the electric resistance film 1 with the protective layer 5.

The protective layer 5 is not an essential member in the electromagnetic-wave absorbing sheet of this embodiment. Depending on the material of the conductive organic polymer, there is little concern about the change in the surface electric resistance due to the moisture attached to the surface or the damage of the surface of the electric resistance film 1. In this case, the electromagnetic-wave absorbing sheet can be configured without the protective layer 5.

Moreover, the protective layer 5 may be made of a resin material such as polyethylene terephthalate as described later. Although the resin material used as the protective layer 5 has a certain resistance, the influence of the resistance of the protective layer 5 on the surface electric resistance of the electromagnetic-wave absorbing sheet can be reduced to a level having no problem in practical use by setting the thickness of the protective layer 5 thin.

Next, members constituting the electromagnetic-wave absorbing sheet of this embodiment will be described in detail.

### [Electric resistance film]

In the electromagnetic-wave absorbing sheet of this embodiment, the electric resistance film 1 is formed of a conductive organic polymer.

As the conductive organic polymer, a conjugated conductive organic polymer is used, and preferable examples of which include polythiophene and derivatives thereof, and polypyrrole and derivatives thereof.

Specific examples of the polythiophene-based conductive polymer suitably used for the electric resistance film 1 of the electromagnetic-wave absorbing sheet of this embodiment include poly(thiophene), poly(3-methylthiophene), poly(3-ethylthiophene), poly(3-propylthiophene), poly(3-butylthiophene), poly(3-hexylthiophene), poly(3-heptylthiophene), poly(3-octylthiophene), poly(3-decylthiophene), poly(3-dodecylthiophene), poly(3-octadecylthiophene), poly(3-bromothiophene), poly(3-chlorothiophene), poly(3-iodothiophene), poly(3-cyanothiophene), poly(3-phenylthiophene), poly(3,4-dimethylthiophene), poly(3,4-dibutylthiophene), poly(3-hydroxythiophene), poly(3-methoxythiophene), poly(3-ethoxythiophene), poly(3-butoxythiophene), poly(3-hexyloxythiophene), poly(3-heptyloxythiophene), poly(3-octyloxythiophene), poly(3-decyloxythiophene), poly(3-dodecyloxythiophene), poly(3-octadecyloxythiophene), poly(3,4-dihydroxythiophene), poly(3,4-dimethoxythiophene), poly(3,4-diethoxythiophene), poly(3,4-dipropoxythiophene), poly(3,4-dibutoxythiophene), poly(3,4-dihexyloxythiophene), poly(3,4-diheptyloxythiophene), poly(3,4-dioctyloxythiophene), poly(3,4-didecyloxythiophene), poly(3,4-didodecyloxythiophene), poly(3,4-ethylenedioxythiophene), poly(3,4-propylenedioxythiophene), poly(3,4-butenedioxythiophene), poly(3-methyl-4-methoxythiophene), poly(3-methyl-4-ethoxythiophene), poly(3-carboxythiophene), poly(3-methyl-4-carboxythiophene), poly(3-methyl-4-carboxyethylthiophene), and poly(3-methyl-4-carboxybutylthiophene).

Specific examples of the polypyrrole-based conductive polymer suitably used for the electric resistance film 1 include polypyrrole, poly(N-methylpyrrole), poly(3-methylpyrrole), poly(3-ethylpyrrole), poly(3-n-propylpyrrole), poly(3-butylpyrrole), poly(3-octylpyrrole), poly(3-decylpyrrole), poly(3-dodecylpyrrole), poly(3,4-dimethylpyrrole), poly(3,4-dibutylpyrrole), poly(3-carboxypyrrole), poly(3-methyl-4-carboxypyrrole), poly(3-methyl-4-carboxyethylpyrrole), poly(3-methyl-4-carboxybutylpyrrole), poly(3-hydroxypyrrole), poly(3-methoxypyrrole), poly(3-ethoxypyrrole), poly(3-butoxypyrrole), poly(3-hexyloxypyrrole), poly(3-methyl-4-hexyloxypyrrole), and poly(3-methyl-4-hexyloxypyrrole).

In addition, an organic polymer whose main chain is composed of a π conjugated system may be used as the electric resistance film 1. Examples of such an organic polymer include polyacetylene-based conductive polymers, polyphenylene-based conductive polymers, polyphenylene vinylene-based conductive polymers, polyaniline-based conductive polymers, polyacene-based conductive polymers, polythiophene vinylene-based conductive polymers, and copolymers of these.

As the conductive organic polymer used for the electric resistance film, polyanion may be used as a counter anion. Although not particularly limited, it is preferred that the polyanion contains an anion group that enables the conjugated conductive organic polymer used for the electric resistance film to cause chemical oxidation doping. Examples of such an anion group include groups expressed by General Formulae -O-SO₃X, -O-PO(OX)₂, -COOX, and -SO₃X (in each formula, X represents a hydrogen atom or an alkali metal atom). Among them, the groups expressed by -SO₃X and -O-SO₃X are particularly preferred because of their excellent doping effects on the conjugated conductive organic polymer.

Specific examples of the polyanion include: polymers having a sulfonic group such as polystyrene sulfonic acid, polyvinyl sulfonic acid, polyallyl sulfonic acid, polyacryl sulfonic acid, polymethacryl sulfonic acid, poly(2-acrylamide-2-methylpropanesulfonic acid), polyisoprene sulfonic acid, polysulfoethyl methacrylate, poly(4-sulfobutyl methacrylate), and polymethacryloxybenzene sulfonic acid; and polymers having a carboxylic group such as polyvinyl carboxylic acid, polystyrene carboxylic acid, polyallyl carboxylic acid, polyacryl carboxylic acid, polymethacryl carboxylic acid, poly(2-acrylamide-2-methylpropanecarboxylic acid), polyisoprene carboxylic acid, and polyacrylic acid. The polyanion may be a homopolymer of one of them or a copolymer of two or more of them.

One of the polyanions may be used alone, or two or more of the polyanions may be used in combination. Among the polyanions, polymers having a sulfonic group are preferred, and polystyrene sulfonic acid is more preferred.

One of the conductive organic polymers may be used alone, or two or more of the conductive organic polymers may be used in combination. Among the materials exemplified above, polymers composed of one or two selected from polypyrrole, poly(3-methoxythiophene), poly(3,4-ethylenedioxythiophene), poly(2-aniline sulfonic acid), and poly(3-aniline sulfonic acid) are preferred from the viewpoint of enhancing transparency and conductivity.

Particularly, it is preferable to use poly(3,4-ethylenedioxythiophene: PEDOT) and polystyrene sulfonic acid (PSS) as a combination of the conjugated conductive organic polymer and the polyanion.

In the electric resistance film 1 of this embodiment, a dopant may be used in combination with the conductive organic polymer to control the electric conductivity of the conductive organic polymer and match the input impedance of the electromagnetic-wave absorbing sheet to the impedance in the air. Examples of the dopant include halogens such as iodine and chlorine, Lewis acids such as BF₃ and PF₅, proton acids such as nitric acid and sulfuric acid, transition metals, alkali metals, amino acids, nucleic acids, surfactants, pigments, chloranil, tetracyanoethylene, and TCNQ. More specifically, it is preferable to set the surface electric resistance of the electric resistance film 1 to about plus or minus several percent of 377Ω. The blending ratio between the conductive organic polymer and the dopant may be, e.g., conductive polymer : dopant = 1 : 2 to 1 : 4 in mass ratio.

It is preferred that the electric resistance film 1 further contains polyvinylidene fluoride.

Polyvinylidene fluoride functions as a binder in the conductive organic polymer film by being added to a composition for coating the conductive organic polymer, thereby improving film formability while enhancing the adhesion with a substrate.

Moreover, it is preferred that the electric resistance film 1 contains water-soluble polyester. Since the water-soluble polyester is highly compatible with the conductive polymer, the water-soluble polyester can fix the conductive polymer in the electric resistance film 1 by being added to the coating composition of the conductive organic polymer constituting the electric resistance film 1, thereby allowing the film to be more homogeneous. As a result of the use of the water-soluble polyester, the surface electric resistance is less likely to change even in more severe high temperature and high humidity environments, and it is possible to maintain a state in which the impedances between the electromagnetic-wave absorbing sheet and the air are matched.

Since the electric resistance film 1 including polyvinylidene fluoride and water-soluble polyester can have higher weather resistance, the change in the surface electric resistance of the electric resistance film 1 over time is reduced, and it is possible to constitute a highly reliable electromagnetic-wave absorbing sheet that can maintain stable electromagnetic-wave absorbing properties.

The content of the conductive organic polymer in the electric resistance film 1 is preferably 10 mass% or more and 35 mass% or less based on the total mass of the solid content in the composition of the electric resistance film 1. If the content of the conductive organic polymer is less than 10 mass%, the conductivity of the electric resistance film 1 tends to decrease. If the surface electric resistance of the electric resistance film 1 is set within a predetermined range for impedance matching, the thickness of the electric resistance film 1 tends to increase, which increases the thickness of the electromagnetic-wave absorbing sheet as a whole and deteriorates optical characteristics. Meanwhile, if the content of the conductive organic polymer exceeds 35 mass%, the coating appropriateness at the time of coating the electric resistance film 1 tends to decrease due to the structure of the conductive organic polymer, which makes it difficult to form a favorable electric resistance film 1, increases the haze of the electric resistance film 1, and deteriorates optical characteristics.

The electric resistance film 1 can be formed by applying the coating composition that is a coating material for forming the electric resistance film onto a base and drying it as described above.

The application method of the coating material for forming the electric resistance film onto a base may be, e.g., bar coating, reverse coating, gravure coating, microgravure coating, die coating, dip coating, spin coating, slit coating, or spray coating. Drying after the application is not particularly limited as long as it is performed under the condition that allows a solvent component of the coating material for forming the electric resistance film to evaporate, but it is preferably performed at 100°C to 150°C for 5 to 60 minutes. If a solvent remains in the electric resistance film 1, the strength tends to deteriorate. The drying method may be, e.g., hot-air drying, heat drying, vacuum drying, or natural drying. The electric resistance film 1 may be formed by curing the coated film by irradiation with UV light (ultraviolet light) or EB (electron beams) as needed.

The base constituting the electric resistance film 1 is not particularly limited, but it is preferably a transparent base having transparency. Various materials such as resin, rubber, glass, and ceramics can be used as the material of the transparent base.

By forming the electric resistance film 1 having a surface electric resistance of 377 Ω/sq using the conductive organic polymer, the input impedance of the electromagnetic-wave absorbing sheet of this embodiment can be matched to the impedance in the air. Thereby, reflection or scattering of electromagnetic waves on the surface of the electromagnetic-wave absorbing sheet can be reduced, and more favorable electromagnetic-wave absorbing properties can be obtained.

### [Dielectric layer]

The dielectric layer 2 of the electromagnetic-wave absorbing sheet of this embodiment can be formed of a dielectric such as titanium oxide, polyvinylidene fluoride, polyester resin, glass, or silicone rubber. The dielectric layer 2 may be a single layer formed of one material, or a stack of two or more layers formed of the same material or different materials. The formation method of the dielectric layer 2 may be an application method, press molding, or extrusion molding.

As described above, the electromagnetic-wave absorbing sheet of this embodiment is an electric-wave interference type (λ/4 type) electromagnetic-wave absorbing sheet that absorbs electromagnetic waves by shifting the phase of electromagnetic waves incident upon the electromagnetic-wave absorbing sheet and the phase of reflected waves reflected by the electromagnetic-wave shielding layer by 1/2 wavelength to make the incident waves and the reflected waves cancel each other out. Therefore, the thickness of the dielectric layer (d in FIG. 1) is determined corresponding to the wavelength of electromagnetic waves to be absorbed.

Incidentally, d = λ/4 is established when an interspace between the electric resistance film 1 and the electromagnetic-wave shielding layer 3 is a space, i.e., the dielectric layer 2 is constituted by air. When the dielectric layer 2 is formed of a material having permittivity of εᵣ, the thickness d becomes d = 1/4λ(εᵣ)^{-1/2}. By using a material having large permittivity as a material constituting the dielectric layer 2, the thickness d of the dielectric layer 2 can be reduced by (εᵣ)^{-1/2}, and the thickness of the electromagnetic-wave absorbing sheet as a whole can be reduced. The permittivity is preferably as large as possible, with the upper limit being about 10.

Since the electromagnetic-wave absorbing sheet of this embodiment has flexibility, it is more preferred that the dielectric layer 2 constituting the electromagnetic-wave absorbing sheet and the electromagnetic-wave absorbing sheet itself are as thin as possible, so that the sheet can be bent easily. Further, considering that in many cases the electromagnetic-wave absorbing sheet of this embodiment is to be attached via the adhesive layer 4 (described later), etc., to a member whose electromagnetic-wave leakage is desired to be prevented, it is preferred that the electromagnetic-wave absorbing sheet is thin and easily conforms to the shape of an attachment part, and that the weight of the sheet is reduced further.

As compared with the case of arranging the electric resistance film 1 at a position λ/4 away from the electromagnetic-wave shielding layer 3, the use of the dielectric layer 2 having permittivity of εᵣ between the electromagnetic-wave shielding layer 3 and the electric resistance film 1 can set the thickness d to d = λ/(4(εᵣ)^{1/2}), and thus the thickness of the dielectric layer 2 is reduced. By adjusting the permittivity of εᵣ or the thickness of the dielectric layer 2, it is possible to control the wavelength of electromagnetic waves to be absorbed by the electromagnetic-wave absorbing sheet provided with the dielectric layer 2.

### [Electromagnetic-wave shielding layer]

The electromagnetic-wave shielding layer 3 of the electromagnetic-wave absorbing sheet of this embodiment reflects electromagnetic waves incident from the surface film 1, which is disposed on the opposite side of the electromagnetic-wave absorbing sheet via the dielectric layer 2.

The material constituting the electromagnetic-wave shielding layer 3 is preferably a metal foil, and various kinds of metal foils such as a copper foil, an aluminum foil, and a gold foil can be used. Among them, the electromagnetic-wave shielding layer 3 is preferably an aluminum foil considering the cost and influences of oxidation in the air. When the electromagnetic-wave shielding layer 3 is formed of a metal foil, the layer 3 can be constituted by rolling a metal material. When the electromagnetic-wave shielding layer 3 is formed of a deposited film, it is preferable to appropriately select a vacuum evaporation method from those conventionally used for forming various deposited films, in accordance with a metal material to deposit.

Since the electromagnetic-wave absorbing sheet has flexibility, the thickness of the electromagnetic-wave shielding layer 3 in the case of using an aluminum foil is preferably 1 µm to 20 µm.

In the electromagnetic-wave absorbing sheet of this embodiment, the electromagnetic-wave shielding layer 3 may be a deposited film of a conductive material such as metal. Particularly, by forming a metal deposited film on a surface of the dielectric layer 2 on a side opposite to the side where the electric resistance film 1 is formed, a gap is not formed between the dielectric layer 2 and the electromagnetic-wave shielding layer 3 as compared with the case of separately forming the dielectric layer 2 and the electromagnetic-wave shielding layer 3 and arranging them in close contact with each other. Thereby, electromagnetic waves penetrating the dielectric layer 2 can be reflected at the surface of the dielectric layer 2 on the back side. Electromagnetic waves of a desired frequency can be absorbed by controlling the thickness d of the dielectric layer 2.

In the case of using a deposited film as the electromagnetic-wave shielding layer 3, it is necessary to form the deposited film carefully as compared with the case of using a metal foil so that the density of the conductive material in the deposited film would be uniform and the film would have enough thickness. According to the examination results of the surface electric resistance of the electromagnetic-wave shielding layer 3 (described later), it is preferred that the surface electric resistance of the electromagnetic-wave shielding layer 3 is 1 x 10⁻¹ Ω/sq or less, and that the surface electric resistance is set to a predetermined value or less by adequately controlling the thickness of the metal deposited film.

The electromagnetic-wave shielding layer 3 may be constituted, other than as the metal deposited film formed on the back side of the dielectric layer 2, by evaporating and depositing a metal material on a surface of a sheet member made of a nonmetal material having flexibility and arranging the metal deposited surface in contact with the dielectric layer 2.

### [Adhesive layer]

By providing the adhesive layer 4 in the electromagnetic-wave absorbing sheet of this embodiment, the electromagnetic-wave absorbing sheet, which is a stack of the electric resistance film 1, the dielectric layer 2 and the electromagnetic-wave shielding layer 3, can be attached to a desired position such as an inner surface of a housing that contains an electric circuit, or an inner surface or outer surface of an electric device. Specifically, since the electromagnetic-wave absorbing sheet of this embodiment has flexibility, it can be attached easily even on a curved surface (bent surface). Thus, the adhesive layer 4 provided on the back surface improves the handleability of the electromagnetic-wave absorbing sheet.

The adhesive layer 4 may be formed of a known material generally used as an adhesive layer such as an adhesive tape, and specific examples of which include an acrylic adhesive, a rubber adhesive, and a silicone adhesive. A tackifier or crosslinking agent may be used to adjust the tackiness with respect to an adherend or to reduce adhesive residues. The tackiness with respect to an adherend is preferably 5 N/10 mm to 12 N/10 mm. If the tackiness is smaller than 5 N/10 mm, the electromagnetic-wave absorbing sheet may be easily peeled off or displaced from an adherend. If the tackiness is larger than 12 N/10 mm, the electromagnetic-wave absorbing sheet is difficult to be peeled off from an adherend.

The thickness of the adhesive layer 4 is preferably 20 µm to 100 µm. If the adhesive layer 4 is thinner than 20 µm, the tackiness is low and the electromagnetic-wave absorbing sheet may be easily peeled off or displaced from an adherend. If the adhesive layer 4 is thicker than 100 µm, the electromagnetic-wave absorbing sheet is difficult to be peeled off from an adherend. If cohesion of the adhesive layer is low, an adhesive may remain on an adherend when the electromagnetic-wave absorbing sheet is peeled off from the adherend, and the flexibility of the electromagnetic-wave absorbing sheet as a whole may decrease.

The adhesive layer 4 for the electromagnetic-wave absorbing sheet of this embodiment may be an adhesive layer 4 that makes the electromagnetic-wave absorbing sheet unpeelably attached to an adherend, or as an adhesive layer 4 that makes the electromagnetic-wave absorbing sheet peelably attached to an adherend. Further, as described above, the adhesive layer 4 is not essential in the electromagnetic-wave absorbing sheet of this embodiment, and various conventional adhesion methods can be adopted to attach the electromagnetic-wave absorbing sheet to a desired member.

### [Protective layer]

In the electromagnetic-wave absorbing sheet of this embodiment, the protective layer 5 may be provided on a surface of the electric resistance film 1 on the electromagnetic-wave incident side.

In the electromagnetic-wave absorbing sheet of this embodiment, the conductive organic polymer used as the electric resistance film 1 may change the surface electric resistance by humidity in the air. By providing the protective layer 5 on the surface of the electric resistance film 1, the influence of humidity can be reduced, and the electromagnetic-wave absorbing properties by impedance matching can be effectively prevented from deteriorating.

In one example, the protective layer 5 in the electromagnetic-wave absorbing sheet of this embodiment may be polyethylene terephthalate having a thickness of 25 µm and attached on the surface of the electric resistance film 1 using an adhesive of a resin material.

The protective layer 5 can prevent the penetration of moisture into the electric resistance film 1 by covering the entire surface of the electric resistance film 1. It is considered that the surface electric resistance of the protective layer 5 formed as a resin film may affect the surface electric resistance of the electric resistance film 1 as a member connected in parallel, and because of this, the influence given to the input impedance of the electromagnetic-wave absorbing sheet is very small as long as the protective layer 5 is not too thick. Moreover, the surface electric resistance of the electric resistance film 1 can be set to a more suitable value by taking into consideration the influence of the surface electric resistance of the protective layer 5 as the input impedance of the electromagnetic-wave absorbing sheet.

It is preferred that the thickness of the protective layer 5 is as thin as possible within a range that can protect the electric resistance film 1. Specifically, the thickness of the protective layer 5 is preferably 150 µm or less, and more preferably 100 µm or less. If the thickness of the protective layer exceeds 150 µm, electromagnetic-wave absorbency may decrease, and the electromagnetic-wave absorption amount may be lower than 20 dB; besides, the thickness of the electromagnetic-wave absorbing sheet as a whole increases, and the flexibility decreases. The thickness of the protective layer is preferably 25 µm or more. If the protective layer is thinner than 25 µm, an effect of preventing scratches decreases.

### [Examples]

Electromagnetic-wave absorbing sheets of this embodiment were actually produced to measure various properties. The following describes the results.

### <Weather resistance of electric resistance film>

Five each of the following two kinds of electromagnetic-wave absorbing sheets were produced by differentiating the components of electric resistance film liquids (liquids for forming electric resistance film).

### (Sheet 1)

An electric resistance film liquid of Sheet 1 was prepared by adding and mixing the following components.

| | | |
|---|---|---|
| (1) Conductive polymer dispersing element | | 36.7 parts |
| | Conductive polymer (PEDOT-PSS) manufactured by Heraeus Holding: PH-1000 (trade name), Solid content concentration: 1.2 mass% | |
| (2) PVDF dispersion | | 5.6 parts |
| | LATEX 32 (trade name) manufactured by Arkema S.A., Solid content concentration: 20 mass%, Solvent: Water | |
| (3) Water-soluble polyester aqueous solution | | 0.6 parts |

PLAS COAT Z561 (trade name) manufactured by GOO CHEMICAL CO., LTD.,

### Solid content concentration: 25 mass%

| | |
|---|---|
| (4) Organic solvent (dimethylsulfoxide) | 9.9 parts |
| (5) Water-soluble solvent (ethanol) | 30.0 parts |
| (6) Water | 17.2 parts |

### (Sheet 2)

An electric resistance film liquid of Sheet 2 was prepared by adding and mixing the following components.

| | | |
|---|---|---|
| (1) Conductive polymer dispersing element | | 33.7 parts |
| | Conductive polymer (PEDOT-PSS) manufactured by Heraeus Holding: PH-1000 (trade name), Solid content concentration: 1.2 mass% | |
| (2) PVDF dispersion | | 5.1 parts |

LATEX 32 (trade name) manufactured by Arkema S.A.,

### Solid content concentration: 20 mass%, Solvent: Water

| | |
|---|---|
| (3) Organic solvent (dimethylsulfoxide) | 9.5 parts |
| (4) Water-soluble solvent(n-propyl alcohol) | 36.0 parts |
| (5) Water | 15.7 parts |

Each electric resistance film was formed by applying the electric resistance film liquid in the proportion described above onto a polyethylene terephthalate sheet (25 µm thick, base) by bar coating, in an amount so that the thickness after drying would be about 120 nm, and the applied liquid was heated at 150°C for five minutes. The surface electric resistances of the electric resistance films thus produced were all 377 Ω/sq.

An urethane rubber having a thickness of 400 µm was used as the dielectric layer, and an aluminum foil having a thickness of 15 µm was used as the electromagnetic-wave shielding layer. The electric resistance film, the dielectric layer, and the electromagnetic-wave absorbing layer were stacked in this order in close contact with each other and attached to each other using an adhesive.

### (Test conditions)

The initial surface electric resistances of Sheet 1 (n = 5) and Sheet 2 (n = 5) produced above were measured. All of the electromagnetic-wave absorbing sheets were placed in a thermo-hygrostat and stored for 500 hours at 60°C under a relative humidity of 90%. Subsequently, the surface electric resistances of the electric resistance films of the electromagnetic-wave absorbing sheets after storage were measured. Then, surface electric resistance change rates were calculated by Formula below, and an average of the surface electric resistance change rates of the five (n = 5) electromagnetic-wave absorbing sheets were calculated. Surface electric resistance change rate (%) = [(Surface electric resistance after storage - Initial surface electric resistance) / Initial surface electric resistance] x 100

As a result of the above measurement, the average of the surface electric resistance change rates of the five (n = 5) electromagnetic-wave absorbing sheets was 8% for Sheet 1 and 18% for Sheet 2. The surface electric resistance change rate of 8% of Sheet 1 corresponds to about 30 Ω with respect to 377 Ω, which is judged that Sheet 1 has high stability in practical use considering the severe weather-resistance test conditions. The surface electric resistance change rate of 18% of Sheet 2 corresponds to about 68 Ω with respect to 377Ω, which is judged that Sheet 2 has enough stability in practical use.

The results of the weather resistance test using Sheet 1 and Sheet 2 indicate that, by adding the water-soluble polyester aqueous solution to the electric resistance film, the hygroscopicity of the electric resistance film is lowered, and thus it is possible to constitute an electromagnetic-wave absorbing sheet having stable electromagnetic-wave absorbing properties with less change in surface electric resistance.

### <Effects of impedance matching>

Next, the change in the electromagnetic-wave absorbing properties depending on the difference in the surface electric resistances of the electric resistance films in the electromagnetic-wave absorbing sheets of this embodiment was examined by actually producing electromagnetic-wave absorbing sheets (Sheet 3 to Sheet 6) with electric resistance films having different surface electric resistances.

### (Production of sheets)

Electromagnetic-wave absorbing sheets were produced in the following manner. Electric resistance films having different thicknesses were formed by applying the electric resistance film liquid of Sheet 1 onto a 300-µm-thick polyethylene terephthalate (base) in different thicknesses by bar coating, followed by heating at 150°C for five minutes. Then, a 250-µm-thick polyethylene terephthalate sheet was attached to a surface of the polyethylene terephthalate (base) using an adhesive on a side opposite to the side where the electric resistance film layer was formed. As a result, the dielectric layer 2 of polyethylene terephthalate having a thickness of 550 µm was formed. The electromagnetic-wave shielding layer 3 was formed using a 15-µm-thick aluminum foil on a side of the 250-µm-thick polyethylene terephthalate sheet opposite to the electric resistance film. The center frequency of electromagnetic waves to be absorbed by each electromagnetic-wave absorbing sheet thus produced was 76 GHz.

The thicknesses and surface electric resistances of the electric resistance films after drying of the electromagnetic-wave absorbing sheets were as below.
(Sheet 3) Electric resistance film layer, thickness: 140 nm, surface electric resistance: 320 Ω/sq
(Sheet 4) Electric resistance film layer, thickness: 92 nm, surface electric resistance: 452 Ω/sq
(Sheet 5) Electric resistance film layer, thickness: 150 nm, surface electric resistance: 302 Ω/sq
(Sheet 6) Electric resistance film layer, thickness: 88 nm, surface electric resistance: 471 Ω/sq

### (Measurement of electromagnetic-wave absorbing properties)

The electromagnetic-wave absorbing properties of Sheet 3 to Sheet 6 produced above as well as Sheet 1, which is the electromagnetic-wave absorbing sheet including the electric resistance film having a surface electric resistance of 377 Ω/sq (the same as the impedance in the air), were measured in accordance with a free space method. Specifically, a free space measuring device manufactured by KEYCOM Corporation and a vector network analyzer MS4647 B (trade name) manufactured by ANRITSU CORPORATION were used to determine a ratio between the intensity of incident waves and the intensity of reflected waves as a voltage at the time of irradiating each electromagnetic-wave absorbing sheet with electromagnetic waves.

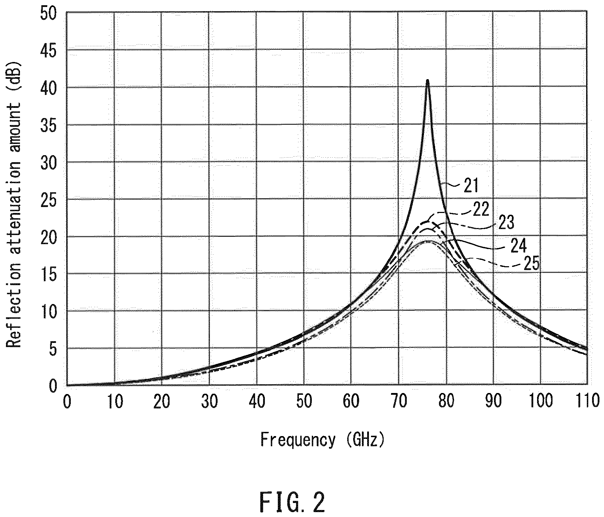

FIG. 2 indicates electromagnetic-wave absorbing properties of each electromagnetic-wave absorbing sheet measured in the above-described manner. In FIG. 2, the attenuation amount of the intensity of reflected waves with respect to the intensity of incident waves is expressed in dB.

In FIG. 2, reference numeral 21 indicates the electromagnetic-wave absorbing properties of Sheet 1, reference numeral 22 indicates the electromagnetic-wave absorbing properties of Sheet 3, reference numeral 23 indicates the electromagnetic-wave absorbing properties of Sheet 4, reference numeral 24 indicates the electromagnetic-wave absorbing properties of Sheet 5, and reference numeral 25 indicates the electromagnetic-wave absorbing properties of Sheet 6.

FIG. 2 indicates that Sheet 1, including the electric resistance film having a surface electric resistance of 377 Ω/sq, matched the impedance in the air (vacuum) and achieved extremely favorable impedance matching, resulted in extremely high attenuation amount of about 42 dB with respect to electromagnetic waves of 76 GHz.

Sheet 3, including the electric resistance film having a surface electric resistance of 320 Ω/sq (shifted by -15% from the vacuum impedance (377Ω)), resulted in the electromagnetic-wave attenuation amount of about 22 dB at 76 GHz, and Sheet 4, including the electric resistance film having a surface electric resistance of 452 Ω/sq (shifted by +20% from the vacuum impedance), resulted in the electromagnetic-wave attenuation amount of about 21 dB at 76 GHz. Both of these sheets exceeded the electromagnetic-wave attenuation amount of 20 dB (attenuation rate: 99%) and exhibited favorable electromagnetic-wave absorbing properties.

Meanwhile, Sheet 5, including the electric resistance film having a surface electric resistance of 302 Ω/sq (shifted by -20% from the vacuum impedance (377 Ω)), and Sheet 6, including the electric resistance film having a surface electric resistance of 471 Ω/sq (shifted by +25% from the vacuum impedance), both resulted in the electromagnetic-wave attenuation amount of about 19 dB at 76 GHz. It is considered that the attenuation amount of about 20 dB or more is practically sufficient electromagnetic-wave absorbing properties as the electromagnetic-wave absorbing sheet. By setting the surface electric resistance of the electric resistance film within a range from -15% to +20% with respect to the vacuum impedance, the electromagnetic-wave attenuation amount of 20 dB (attenuation rate: 99%) or more can be obtained, and an electromagnetic-wave absorbing sheet having favorable electromagnetic-wave absorbing properties can be obtained.

### [Surface electric resistance of electromagnetic-wave shielding layer]

Next, conditions of the electromagnetic-wave shielding layer under which electromagnetic waves can be favorably reflected were checked.

The electromagnetic-wave shielding layer of Sheet 1 and other three kinds of electromagnetic-wave shielding layers of Sheet 7 to Sheet 9 were used. In Sheet 1, only the electromagnetic-wave shielding layer among the electric resistance film, the dielectric layer, and the electromagnetic-wave shielding layer was used. The intensity of electromagnetic waves passing through each of the four sheets including the electromagnetic-wave shielding layer of Sheet 1 was measured in accordance with a free space method.

The configurations and surface electric resistances of the electromagnetic-wave shielding layers to be measured were as below.
(Sheet 1) Aluminum foil (t = 15 µm), resistance: 1.9 x 10⁻³ Ω/sq
(Sheet 7) Copper deposited film (t = 0.5 µm), resistance: 1.0 x 10⁻¹ Ω/sq (formed on a 50-µm-thick polyethylene terephthalate sheet)
(Sheet 8) Aluminum deposited film (t = 50 nm), resistance: 2.0 Ω/sq (formed on a 50-µm-thick polyethylene terephthalate sheet)
(Sheet 9) Aluminum plate (t = 5 mm), resistance: 1.0 x 10⁻⁴ Ω/sq

In the free space method, the intensity of electromagnetic waves passing through each electromagnetic-wave shielding layer was measured in accordance with Parameter S21 using the free space measuring device manufactured by KEYCOM Corporation and the vector network analyzer MS4647 B (trade name) manufactured by ANRITSU CORPORATION. The surface electric resistance of each electromagnetic-wave shielding layer was measured using a Loresta-GP MCP-T610 (trade name) manufactured by Mitsubishi Chemical Analytech Co., Ltd.

The intensity of electromagnetic waves passing through the electromagnetic-wave shielding layer of Sheet 9 (5-mm-thick aluminum plate not having flexibility) (the attenuation amount of the intensity of transmitted waves from the intensity of input waves) was set as a reference (= 100%). The attenuation amount of the electromagnetic-wave shielding layer of Sheet 1 was 98%, and the attenuation amount in Sheet 7 was 97%, indicating that the properties of both of the electromagnetic-wave shielding layers are enough in practical use. Meanwhile, the attenuation amount of transmitted electromagnetic waves in Sheet 8 was as small as 42%, indicating that many electromagnetic waves passed through the electromagnetic-wave absorbing sheet.

The electromagnetic-wave absorbing sheet of this embodiment is an electric-wave interference type electromagnetic-wave absorbing sheet in which the electromagnetic-wave shielding layer is provided on the back side of the sheet different from the electromagnetic-wave incident side. It is not preferred as electromagnetic-wave absorbing properties that the intensity of electromagnetic waves passing through the electromagnetic-wave absorbing sheet is high. From this viewpoint, it is preferred that the surface electric resistance of the electromagnetic-wave shielding layer used in the electromagnetic-wave absorbing sheet of this embodiment is 1.0 x 10⁻¹ Ω/sq or less. Incidentally, in Sheet 7 and Sheet 8, different metals (copper and aluminum) were used in the deposited films constituting the electromagnetic-wave shielding layers. Considering that the electromagnetic-wave shielding layer is a layer to reflect electromagnetic waves, almost no difference is made depending on the metal material to be used, and the surface electric resistance of the formed electromagnetic-wave shielding layer affects the properties of the electromagnetic-wave shielding layer as a layer reflecting electromagnetic waves.

### [Effect of protective layer]

Next, an effect obtained by stacking the protective layer on the surface of the electric resistance film was examined.

Sheet 10 was produced by using Sheet 1 as an electromagnetic-wave absorbing sheet and a 25-µm-thick polyethylene terephthalate sheet with an adhesive layer as a as a protective layer, and attaching the polyethylene terephthalate sheet to the surface of the electric resistance film.

Two each of Sheet 1 and Sheet 10 were prepared. A total of four electromagnetic-wave absorbing sheets were each subjected to a dry-wiping sliding test to measure the presence or absence of abrasion on the surface sheet member and the change in the surface electric resistance. The dry-wiping sliding test was performed using a HEIDON sliding test machine set with a white flannel cloth under the following conditions: weight: 2000 g, sliding rate: 4500 mm/min, sliding width: 25 mm, and sliding frequency: 1000 passes (about 10 minutes).

The electromagnetic-wave absorbing sheets after the test were observed. No abrasion was found visually on any of the two each of Sheet 1 and Sheet 10. As to the surface electric resistances of the electric resistance films of the electromagnetic-wave absorbing sheets, the two Sheets 10 provided with the protective layer had no change in the resistance, whereas the two Sheets 1 not provided with the protective layer increased the surface electric resistance by 16% and 10%, respectively. The reason for this is considered to be that the electric resistance films of the electromagnetic-wave absorbing sheets not provided with the protective layer were scraped during the sliding test, and the thicknesses were reduced and the surface electric resistances increased.

The above results confirmed the following. The change in the surface electric resistance of the electric resistance film collapses the impedance matching and deteriorates the electromagnetic-wave absorbing properties. By providing the protective layer, the change in the thickness of the electric resistance film due to mechanical factors can be reduced, and it is possible to configure an electromagnetic-wave absorbing sheet having stable electromagnetic-wave absorbing properties.

### [Confirmation of flexibility]

Next, it was confirmed that by using the conductive organic polymer as the electric resistance film in the electromagnetic-wave absorbing sheet of this embodiment, the sheet can have flexibility.

Sheet 11 including an electric resistance film having a surface electric resistance of 370 Ω/sq formed by sputtering indium tin oxide (ITO) was produced as a comparative example. A dielectric layer and an electromagnetic-wave shielding layer of Sheet 11 were configured in the same manner as those of Sheet 1.

Sheet 1 and Sheet 11 were each cut into a size of 5 x 10 cm, and their initial surface electric resistances were measured. Next, the sheets were placed on a horizontally arranged aluminum cylindrical rod (mandrel) 10 mm in diameter so that the electric resistance film would face upward. A weight of 300 g was attached to both ends of the sheets and this state was maintained for 30 seconds. The both ends of the sheets were pulled downward with the center of the sheets being bent. Then, the surface electric resistances of the electromagnetic-wave absorbing sheets were measured.

Next, the same test was performed by changing the aluminum cylindrical rod around which the sheets were to be wound, to an aluminum cylindrical rod (mandrel) 6 mm in diameter.

As a result, in the case of the aluminum cylindrical rod (mandrel) 10 mm in diameter, the surface electric resistances of the electric resistance films of Sheet 1 and Sheet 11 did not change. In the case of the aluminum cylindrical rod (mandrel) 6 mm in diameter, the surface electric resistance of the electric resistance film of Sheet 1 did not change, but the surface electric resistance of the electric resistance film of Sheet 11 was increased to 750 Ω/sq, which is about twice the initial surface electric resistance.

A microscope was used to observe the surface conditions of the electromagnetic-wave absorbing sheets wounded around the aluminum cylindrical rod (mandrel) 6 mm in diameter. No change was observed on the surface of Sheet 1, but there were cracks on the surface of Sheet 11.

The above result confirmed that, by using the conductive organic polymer as the electric resistance film in the electromagnetic-wave absorbing sheet of this embodiment, the flexibility of the sheet improves, and the sheet can maintain electromagnetic-wave absorbing properties even when a load that causes the sheet to bent strongly is applied to the sheet.

As described above, the electromagnetic-wave absorbing sheet of this embodiment can maintain electromagnetic-wave absorbing properties even when strongly bent, by forming the electric resistance film on the surface on the electromagnetic-wave incident side using the conductive organic polymer. Thereby, it is possible to constitute an electromagnetic-wave absorbing sheet having stable and high electromagnetic-wave absorbing properties and flexibility.

### Industrial Applicability

The electromagnetic-wave absorbing sheet disclosed in the present application is useful as an electromagnetic-wave absorbing sheet that can stably absorb electromagnetic waves in a high frequency band equal to or higher than the millimeter-wave band.

### Description of Reference Numerals

- 1: Electric resistance film
- 2: Dielectric layer
- 3: Electromagnetic-wave shielding layer
- 4: Adhesive layer
- 5: Protective layer

## Claims

1. An electromagnetic-wave absorbing sheet having flexibility, comprising an electric resistance film (1) and a dielectric layer (2) and an electromagnetic-wave shielding layer (3) that are stacked sequentially, **characterized in that** the electric resistance film (1) is formed of a conductive organic polymer, wherein the electromagnetic-wave absorbing sheet does not crack after being subjected to a flexibility evaluation test, and
a surface electric resistance of the electromagnetic-wave absorbing sheet does not increase after being subjected to the flexibility evaluation test comprising:
placing the sheet on a horizontally arranged aluminum cylindrical rod having a diameter of 6 mm so that the electric resistance film faces upward; and
attaching a weight of 300 g to both ends of the sheet and maintaining this state for 30 seconds to pull the ends of the sheet downward with the center of the sheet being bent.

2. The electromagnetic-wave absorbing sheet according to claim 1, wherein the electric resistance film (1) contains poly(3,4-ethylenedioxythiophene).

3. The electromagnetic-wave absorbing sheet according to claim 2, wherein the electric resistance film (1) further contains polystyrene sulfonic acid and polyvinylidene fluoride.

4. The electromagnetic-wave absorbing sheet according to claim 2 or 3, wherein the electric resistance film (1) further contains water-soluble polyester.

5. The electromagnetic-wave absorbing sheet according to any of claims 1 to 4, wherein a surface electric resistance of the electric resistance film (1) is in a range from -15% to +20% with respect to a vacuum impedance.

6. The electromagnetic-wave absorbing sheet according to any of claims 1 to 5, wherein a surface electric resistance of the electromagnetic-wave shielding layer (3) is 1 x 10⁻¹ Ω/sq or less.

7. The electromagnetic-wave absorbing sheet according to any of claims 1 to 6, wherein a thickness (d) of the dielectric layer is set so that the dielectric layer can absorb electromagnetic waves in a high frequency band equal to or higher than a millimeter-wave band.

8. The electromagnetic-wave absorbing sheet according to any of claims 1 to 7, further comprising an adhesive layer (4) on a back surface of the electromagnetic-wave shielding layer (3).

9. The electromagnetic-wave absorbing sheet according to any of claims 1 to 8, further comprising a protective layer (5) that covers the electric resistance film (1).

10. The electromagnetic-wave absorbing sheet according to any of claims 1 to 9, wherein the presence or absence of a crack is determined as a result of observation of a surface condition of the sheet with a microscope.

11. The electromagnetic-wave absorbing sheet according to any of claims 1 to 10,
wherein the conductive organic polymer is conjugated.

12. The electromagnetic-wave absorbing sheet according to claim 11, wherein the conjugated conductive organic polymer is a polythiophene, a polypyrrole, or a derivative thereof.

## Patentansprüche

1. Elektromagnetische Wellen absorbierende Folie mit Flexibilität, umfassend einen Elektrischer-Widerstands-Film (1) und eine dielektrische Schicht (2) und eine Elektromagnetische-Wellen-Abschirmschicht (3), die sequenziell gestapelt sind, **dadurch gekennzeichnet, dass**
der Elektrischer-Widerstands-Film (1) aus einem leitfähigen organischen Polymer gebildet ist,
wobei die elektromagnetische Wellen absorbierende Folie nicht reißt, nachdem sie einem Flexibilitäts-Beurteilungstest unterzogen worden ist, und
sich ein elektrischer Oberflächenwiderstand der elektromagnetische Wellen absorbierenden Folie nicht erhöht, nachdem sie einem Flexibilitäts-Beurteilungstest unterzogen worden ist, der beinhaltet:
Platzieren der Folie auf einem horizontal angeordneten zylindrischen Aluminiumstab mit einem Durchmesser von 6 mm derart, dass der Elektrischer-Widerstands-Film nach oben weist; und
Anbringen eines Gewichts von 300 g an beiden Enden der Folie und Beibehalten dieses Zustands für 30 Sekunden, um die Enden der Folie nach unten zu ziehen, so dass die Mitte der Folie gebogen wird.

2. Elektromagnetische Wellen absorbierende Folie gemäß Anspruch 1, wobei der Elektrischer-Widerstands-Film (1) Poly(3,4-ethylendioxythiophen) beinhaltet.

3. Elektromagnetische Wellen absorbierende Folie gemäß Anspruch 2, wobei der Elektrischer-Widerstands-Film (1) ferner Polystyrensulfonsäure und Polyvinylidenfluorid beinhaltet.

4. Elektromagnetische Wellen absorbierende Folie gemäß Anspruch 2 oder 3, wobei der Elektrischer-Widerstands-Film (1) ferner wasserlöslichen Polyester beinhaltet.

5. Elektromagnetische Wellen absorbierende Folie gemäß einem der Ansprüche 1 bis 4, wobei der elektrische Oberflächenwiderstand des Elektrischer-Widerstands-Films (1) in einem Bereich von -15% bis +20% bezogen auf die Vakuumimpedanz liegt.

6. Elektromagnetische Wellen absorbierende Folie gemäß einem der Ansprüche 1 bis 5, wobei der elektrische Oberflächenwiderstand der Elektromagnetische-Wellen-Abschirmschicht (3) 1 x 10⁻¹ Ω/□ oder weniger beträgt.

7. Elektromagnetische Wellen absorbierende Folie gemäß einem der Ansprüche 1 bis 6, wobei die Dicke (d) der dielektrischen Schicht derart eingestellt ist, dass die dielektrische Schicht elektromagnetische Wellen in einem Hochfrequenzband gleich oder höher als das Millimeterwellenband zu absorbieren vermag.

8. Elektromagnetische Wellen absorbierende Folie gemäß einem der Ansprüche 1 bis 7, ferner beinhaltend eine Kleberschicht (4) an einer Rückfläche der Elektromagnetische-Wellen-Abschirmschicht (3).

9. Elektromagnetische Wellen absorbierende Folie gemäß einem der Ansprüche 1 bis 8, ferner beinhaltend eine Schutzschicht, die (5) den Elektrischer-Widerstands-Film (1) bedeckt.

10. Elektromagnetische Wellen absorbierende Folie gemäß einem der Ansprüche 1 bis 9, wobei die Anwesenheit oder Abwesenheit eines Risses als Ergebnis von Betrachtung einer Oberflächeneigenschaft der Folie mit einem Mikroskop ermittelt wird.

11. Elektromagnetische Wellen absorbierende Folie gemäß einem der Ansprüche 1 bis 10, wobei das leitfähige organische Polymer konjugiert ist.

12. Elektromagnetische Wellen absorbierende Folie gemäß Anspruch 11, wobei das konjugierte leitfähige organische Polymer ein Polythiophen, ein Polypyrrol oder ein Derivat davon ist.

## Revendications

1. Feuille d'absorption d'ondes électromagnétiques ayant une flexibilité, comprenant un film de résistance électrique (1) et une couche diélectrique (2) et une couche de protection contre les ondes électromagnétiques (3) qui sont empilées séquentiellement, **caractérisée en ce que**
le film de résistance électrique (1) est formé d'un polymère organique conducteur,
dans laquelle la feuille d'absorption d'ondes électromagnétiques ne se fissure pas après avoir été soumise à un test de confirmation de flexibilité, et
une résistance électrique de surface de la feuille d'absorption d'ondes électromagnétiques ne se fissure pas après avoir été soumise à un test de confirmation de flexibilité comprenant :
le placement de la feuille sur une tige cylindrique en aluminium agencée horizontalement ayant un diamètre de 6 mm, de sorte que le film de résistance électrique soit orienté vers le haut ; et
la fixation d'un poids de 300 g aux deux extrémités de la feuille et le maintien de cet état pendant 30 secondes pour tirer les extrémités de la feuille vers le bas, le centre de la feuille étant plié.

2. Feuille d'absorption d'ondes électromagnétiques selon la revendication 1, dans laquelle le film de résistance électrique (1) contient du poly(3,4-éthylènedioxythiophène).

3. Feuille d'absorption d'ondes électromagnétiques selon la revendication 2, dans laquelle le film de résistance électrique (1) contient en outre de l'acide sulfonique de polystyrène et du fluorure de polyvinylidène.

4. Feuille d'absorption d'ondes électromagnétiques selon la revendication 2 ou 3, dans laquelle le film de résistance électrique (1) contient en outre du polyester hydrosoluble.

5. Feuille d'absorption d'ondes électromagnétiques selon l'une quelconque des revendications 1 à 4, dans laquelle une résistance électrique de surface du film de résistance électrique (1) est comprise entre -15 % et +20 % par rapport à l'impédance du vide.

6. Feuille d'absorption d'ondes électromagnétiques selon l'une quelconque des revendications 1 à 5, dans laquelle la résistance électrique de surface de la couche de protection contre les ondes électromagnétiques (3) est inférieure ou égale à 1 x 10⁻¹ Ω/sq.

7. Feuille d'absorption d'ondes électromagnétiques selon l'une quelconque des revendications 1 à 6, dans laquelle une épaisseur (d) de la couche diélectrique est réglée de sorte que la couche diélectrique puisse absorber des ondes électromagnétiques dans une bande de haute fréquence égale ou supérieure à une bande d'ondes millimétriques.

8. Feuille d'absorption d'ondes électromagnétiques selon l'une quelconque des revendications 1 à 7, comprenant en outre une couche adhésive (4) sur une surface arrière de la couche de protection d'ondes électromagnétiques (3).

9. Feuille d'absorption d'ondes électromagnétiques selon l'une quelconque des revendications 1 à 8, comprenant en outre une couche protectrice (5) qui recouvre le film de résistance électrique (1).

10. Feuille d'absorption d'ondes électromagnétiques selon l'une quelconque des revendications 1 à 9, dans laquelle la présence ou l'absence d'une fissure est déterminée par l'observation d'un état de surface de la feuille à l'aide d'un microscope.

11. Feuille d'absorption d'ondes électromagnétiques selon l'une quelconque des revendications 1 à 10, dans laquelle le polymère organique conducteur est conjugué.

12. Feuille d'absorption d'ondes électromagnétiques selon la revendication 11, dans laquelle le polymère organique conducteur conjugué est un polythiophène, un polypyrrole ou un des dérivés de ceux-ci.
